# DEMANDE DE BREVET EUROPEEN

(11) **EP 4 299 506 A1**
(43) Date de publication de la demande: **03.01.2024**
(21) Numéro de dépôt: 23179917.2
(22) Date de dépôt: 19.06.2023
(51) Int. Cl.: B81C 1/00, G02B 3/00, C03C 15/00

(54) **PROCEDE DE FABRICATION DE MICROCAVITES CONCAVES**

(30) Priorité: 28.06.2022 FR 2206427
(71) Demandeur: Commissariat à l'énergie atomique et aux énergies alternatives, 75015 Paris (FR)
(72) Inventeur: MEHREZ, Zouhir, 38054 GRENOBLE CEDEX 9 (FR); RECHE, Jérôme, 38054 GRENOBLE CEDEX 9 (FR)
(74) Mandataire: Cabinet Beaumont

(57) **Abrégé**

La présente description concerne un procédé de fabrication d'une microcavité concave (250) dans une couche (200) d'un premier matériau, comprenant les étapes successives suivantes :
a) former une couche de masque dur (203) sur la couche (200) du premier matériau ;
b) former une ouverture (209) dans la couche de masque dur (203) ; et
c) former la microcavité concave (250) par gravure partielle de la couche (200) du premier matériau à travers l'ouverture (209), par un procédé de gravure à base d'acide fluorhydrique en phase vapeur.

## Description

### Domaine technique

La présente description concerne de façon générale le domaine des procédés de fabrication de microstructures. Elle vise plus particulièrement un procédé de fabrication de microcavités concaves, par exemple en vue de réaliser des microlentilles.

### Technique antérieure

Divers procédés de fabrication de microlentilles ont été proposés. Ces procédés présentent toutefois divers inconvénients. Il serait souhaitable de pouvoir disposer d'un procédé de fabrication de microlentilles palliant tout ou partie des procédés connus de fabrication de microlentilles.

Plus généralement, il serait souhaitable de pouvoir disposer d'un procédé de fabrication de microcavités concaves, palliant tout ou partie inconvénients des procédés connus de fabrication de microcavités concaves.

### Résumé de l'invention

Pour cela, un mode de réalisation prévoit Procédé de fabrication d'une microcavité concave dans une couche d'un premier matériau, comprenant les étapes successives suivantes :
a) former une couche de masque dur sur la couche du premier matériau ;
b) former une ouverture dans la couche de masque dur ; et
c) former la microcavité concave par gravure partielle de la couche du premier matériau à travers l'ouverture, par un procédé de gravure à base d'acide fluorhydrique en phase vapeur.

Selon un mode de réalisation, la couche en le premier matériau est une couche d'oxyde de silicium.

Selon un mode de réalisation, la couche de masque dur est une couche métallique.

Selon un mode de réalisation, la couche de masque dur est en nitrure de titane, en aluminium, en cuivre, ou en un alliage aluminium-cuivre.

Selon un mode de réalisation, la couche de masque dur est en un matériau diélectrique de constante diélectrique supérieure à celle de l'oxyde de silicium.

Selon un mode de réalisation, la couche de masque dur est en nitrure d'aluminium, en alumine, ou en oxyde d'hafnium.

Selon un mode de réalisation, l'ouverture présente une largeur inférieure à 500 nm, de préférence inférieure à 300 nm.

Selon un mode de réalisation, à l'étape b), l'ouverture est formée par gravure à travers une ouverture préalablement formée par photolithographie dans une couche de résine photosensible.

Selon un mode de réalisation, l'ouverture formée à l'étape b) se prolonge à travers une partie de l'épaisseur de la couche en le premier matériau.

Selon un mode de réalisation, le procédé comprend, après l'étape c), une étape de retrait de la couche de masque dur.

Un autre mode de réalisation prévoit l'utilisation du procédé défini ci-dessus pour former des microlentilles optiques.

Un autre mode de réalisation prévoit l'utilisation du procédé défini ci-dessus pour former des microcavités destinées à servir de réceptacle pour des applications de microbiologie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D et la figure 1E sont des vues en coupe illustrant des étapes successives d'un exemple d'un procédé de fabrication d'une microcavité concave ;
la figure 2A, la figure 2B, la figure 2C, la figure 2D et la figure 2E sont des vues en coupe illustrant des étapes successives d'un exemple d'un procédé de fabrication d'une microcavité concave selon un mode de réalisation ; et
la figure 3A, la figure 3B, la figure 3C, la figure 3D et la figure 3E sont des vues en coupe illustrant des étapes successives d'un exemple d'un procédé de fabrication d'une microcavité concave selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites des microcavités, et les systèmes et dispositifs dans lesquels de tels microcavités peuvent être exploitées, n'ont pas été détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

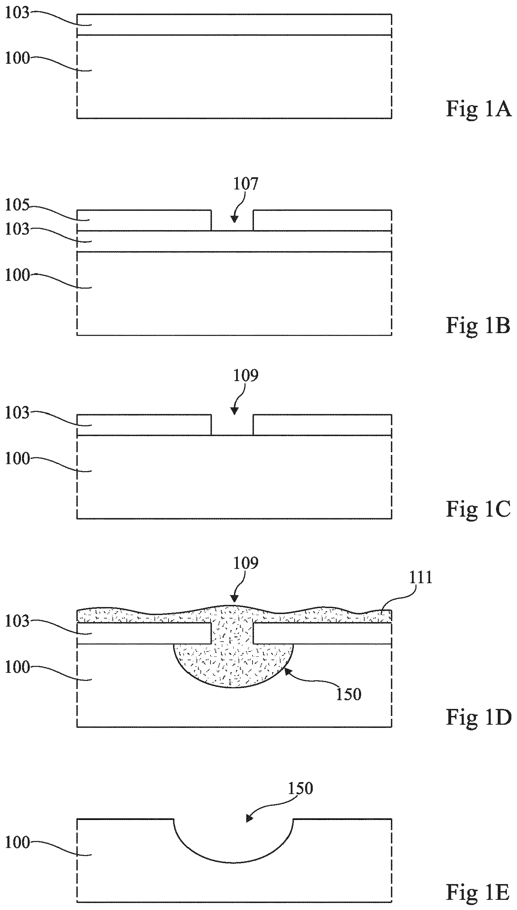

La figures 1A à 1E sont des vues en coupe illustrant de façon schématique des étapes successives d'un exemple d'un procédé de fabrication d'une microcavité concave 150 dans une couche 100.

Sur les figures 1A à 1E, la réalisation d'une unique microcavité 150 a été représentée. En pratique, le procédé peut comprendre la réalisation simultanée, dans une même couche 100, d'une pluralité de microcavités, par exemple un grand nombre de microcavités, par exemple plusieurs milliers de cavités, par exemple identiques aux dispersions de fabrication près, par exemple agencées en matrice selon des rangées et des colonnes. Les microcavités peuvent être jointives ou disjointes.

Par microcavité, on entend ici une cavité dont la plus grande dimension latérale et/ou verticale est inférieure à 1 mm, par exemple inférieure à 10 µm, par exemple de l'ordre de 1 µm, voire inférieures à 1 micromètres.

Par microcavité concave, on entend ici que la cavité présente une surface courbe en creux pénétrant dans la couche 100.

Dans l'exemple représenté, la microcavité 150 est formée du côté de la face supérieure de la couche 100.

La couche 100 est par exemple en un matériau diélectrique, par exemple en dioxyde de silicium (SiO₂). Dans l'exemple représenté, la couche 100 présente des faces inférieure et supérieure planes horizontales, et présente une épaisseur sensiblement homogène sur toute sa surface.

L'épaisseur de la couche 100 est par exemple comprise entre plusieurs dizaines de nanomètres et plusieurs dizaines de micromètres, par exemple entre 50 nm et 50 µm.

La couche 100 peut être disposée sur un support, non représenté, par exemple un substrat en silicium.

La figure 1A illustre une étape de formation d'une couche de masque dur 103 sur la face supérieure de la couche 100, par exemple en contact avec la face supérieure de la couche 100. La couche 103 est par exemple en nitrure de silicium (Si₃N₄). La couche 103 est par exemple formée par dépôt chimique en phase vapeur, par exemple par PECVD (de l'anglais « Plasma-Enhanced Chemical Vapor Déposition » - dépôt chimique en phase vapeur assisté par plasma) ou SACVD (de l'anglais « Sub-Athmospheric Chemical Vapor Déposition » - dépôt chimique en phase vapeur à pression sous-atmosphérique). La couche 103 s'étend par exemple de façon continue et avec une épaisseur sensiblement uniforme sur toute la surface supérieure de la couche 100. L'épaisseur de la couche de masque dur 103 est par exemple comprise entre 20 nm et 350 nm.

La figure 1B illustre une étape de formation d'une couche de masquage 105, par exemple en résine photosensible, sur la face supérieure de la couche de masque dur 103, par exemple en contact avec la face supérieure de la couche de masque dur 103. La couche 105 est par exemple initialement déposée avec une épaisseur sensiblement uniforme sur toute la surface supérieure de la couche de masque dur 103. Une ouverture traversante 107, par exemple de forme cylindrique, est ensuite formée dans la couche de masquage 105, par exemple par photolithographie. L'ouverture 107 débouche sur la face supérieure de la couche de masque dur 103. Les dimensions latérales de l'ouverture 107 sont choisies en fonction des dimensions souhaitées de la microcavité 150. En tout état de cause, les dimensions latérales de l'ouverture 107 sont inférieures aux dimensions latérales de la microcavité 150.

La figure 1C illustre la structure obtenue à l'issue d'une étape de gravure d'une ouverture traversante 109 dans la couche de masque dur 103, en utilisant la couche 105 comme masque de gravure, puis de retrait de la couche 105.

L'ouverture 109 est située à l'aplomb de l'ouverture 107 et alignée verticalement avec l'ouverture 107. L'ouverture 109 présente par exemple des dimensions latérales sensiblement identiques à celles de l'ouverture 107. Dans cet exemple, l'ouverture 109 débouche sur la face supérieure de la couche 100. L'ouverture 109 est par exemple formée par un procédé de gravure plasma.

La figure 1D illustre une étape de formation de la microcavité 150 par gravure partielle de la couche 100 à travers l'ouverture 109 préalablement formée dans la couche de masque dur 103. Dans cet exemple, la microcavité 150 est formée par gravure humide de la couche 100 au moyen d'une solution de gravure liquide 111, par exemple à base d'acide fluorhydrique. Les dimensions de la cavité 150 sont par exemple contrôlées par contrôle du temps d'application de la solution de gravure. Dans l'exemple représenté, la microcavité 150 est non traversante, c'est à dire qu'elle s'étend sur une partie seulement de l'épaisseur de la couche 100. A titre de variante, la microcavité 150 peut être traversante et déboucher sur la face supérieure d'un substrat de support (non représenté) en contact, par sa face supérieure, avec la face inférieure de la couche 100.

La figure 1E illustre la structure obtenue à l'issue d'une étape de retrait de la couche de masque dur 103, par exemple au moyen d'une solution de gravure humide adaptée à graver le matériau de la couche 103 de façon sélective par rapport au matériau de la couche 100. La face supérieure de la couche 100 est ainsi libérée, et la couche 100 comprend, du côté de sa face supérieure, une cavité concave 150, par exemple de forme hémisphérique ou en forme de portion de sphère. La profondeur de la microcavité 150 est inférieure à l'épaisseur de la couche 100.

La microcavité 150 peut être utilisée directement comme microlentille optique concave, ou servir de moule pour la réalisation de microlentilles optiques concaves ou convexes, par exemple en un matériau polymère transparent.

A titre de variante, la microcavité 150 peut avoir d'autres applications. Par exemple, la microcavité 150 peut servir de réceptacle pour des applications microbiologiques, par exemple des applications de séparation et/ou comptage de cellules biologiques.

Une limitation du procédé décrit en relation avec les figures 1A à 1E réside dans le fait que l'utilisation d'une gravure humide en solution liquide laisse peu de latitude quant au contrôle de la forme des microcavités réalisées. En outre, il est difficile par un tel procédé de réaliser des microcavités de très petites dimensions latérales, par exemple de dimensions latérales inférieures à 500 nm. Cette contrainte est notamment liée au phénomène de diffusion des espèces actives de gravure, qui ne se produit plus correctement pour des ouvertures 109 de faibles dimensions latérales, en particulier lorsque l'épaisseur de la couche de masque dur 103 est importante.

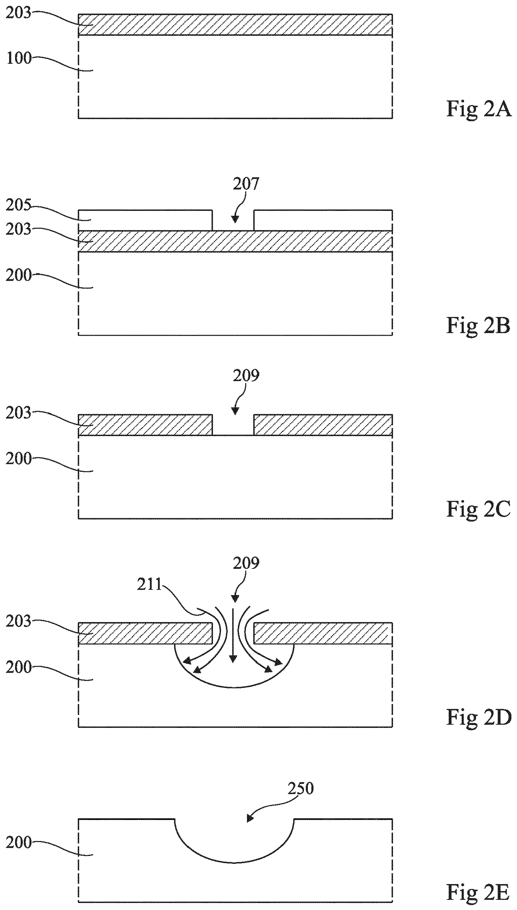

Les figures 2A à 2E sont des vues en coupe illustrant des étapes successives d'un exemple d'un procédé de fabrication d'une microcavité concave 250 dans une couche 200, selon un mode de réalisation.

Sur les figures 2A à 2E, la réalisation d'une unique microcavité 250 a été représentée. En pratique, comme dans l'exemple des figures 1A à 1E, le procédé peut comprendre la réalisation simultanée, dans une même couche 200, d'une pluralité de microcavités.

Dans l'exemple représenté, la microcavité 250 est formée du côté de la face supérieure de la couche 200.

La couche 200 est par exemple identique ou similaire à la couche 100 des figures 1A à 1E.

La figure 2A illustre une étape de formation d'une couche de masque dur 203 sur la face supérieure de la couche 200, par exemple en contact avec la face supérieure de la couche 200. La couche 203 est par exemple en métal ou en un alliage comprenant du métal. A titre d'exemple, la couche 203 est en aluminium, en nitrure de titane (TiN), en cuivre, ou en un alliage aluminium-cuivre. A titre de variante, la couche 203 est en un matériau diélectrique de constante diélectrique élevée, c'est à dire supérieure à celle du dioxyde de silicium, par exemple du nitrure d'aluminium (AlN), de l'alumine (Al₂O₃) ou de l'oxyde d'hafnium (HFO₂). La couche 203 est par exemple formée par dépôt physique en phase vapeur (PVD - de l'anglais « Physical Vapor Déposition »), par dépôt chimique en phase vapeur (CVD - de l'anglais « Chemical Vapor Déposition »), ou encore par dépôt en couche atomiques (ALD - de l'anglais « Atomic Layer Déposition »). La couche 203 s'étend par exemple de façon continue et avec une épaisseur sensiblement uniforme sur toute la surface supérieure de la couche 200. L'épaisseur de la couche de masque dur 203 est par exemple comprise entre 20 nm et 350 nm.

La figure 2B illustre une étape de formation d'une couche de masquage 205, par exemple en résine photosensible, sur la face supérieure de la couche de masque dur 203, puis de formation, dans la couche 205, d'une ouverture traversante 207 débouchant sur la face supérieure de la couche de masque dur 203, par exemple par photolithographie. Cette étape est par exemple identique ou similaire à l'étape décrite en relation avec la figure 1B. Les dimensions latérales de l'ouverture 207 sont choisies en fonction des dimensions souhaitées de la microcavité 250. En tout état de cause, les dimensions latérales de l'ouverture 207 sont inférieures aux dimensions latérales de la microcavité 250.

La figure 2C illustre la structure obtenue à l'issue d'une étape de gravure d'une ouverture traversante 209 dans la couche de masque dur 203, en utilisant la couche 205 comme masque de gravure, puis de retrait de la couche 205.

L'ouverture 209 est située à l'aplomb de l'ouverture 207 et alignée verticalement avec l'ouverture 207. L'ouverture 209 présente par exemple des dimensions latérales sensiblement identiques à celles de l'ouverture 207. Dans cet exemple, l'ouverture 209 débouche sur la face supérieure de la couche 200. Cette étape est par exemple identique ou similaire à l'étape de la figure 1C, en adaptant le procédé de gravure au matériau du masque dur 203. L'ouverture 209 est par exemple formée par un procédé de gravure plasma.

La figure 2D illustre une étape de formation de la microcavité 250 par gravure partielle de couche 200 à travers l'ouverture 209 préalablement formée dans la couche de masque dur 203. Selon un aspect du mode de réalisation des figures 2A à 2E, la microcavité 250 est formée par gravure chimique en phase vapeur au moyen d'un mélange gazeux 211 à base d'acide fluorhydrique en phase vapeur (HF vapeur). Par gravure chimique en phase vapeur, on entend ici une gravure sèche par un processus de gravure essentiellement chimique, plutôt que physique. En particulier, aucun plasma n'est généré dans l'équipement de gravure lors de cette étape. A titre d'exemple, pour la gravure, la structure est placée dans une enceinte comprenant une atmosphère composée majoritairement de HF vapeur, par exemple de plus de 90% de HF vapeur, par exemple de plus de 99% de HF vapeur. Les dimensions de la cavité 150 sont par exemple contrôlées par contrôle du temps d'application de la solution de gravure. Dans l'exemple représenté, la microcavité 250 est non traversante, c'est à dire qu'elle s'étend sur une partie seulement de l'épaisseur de la couche 200. A titre de variante, la microcavité 250 peut être traversante et déboucher sur la face supérieure d'un substrat de support (non représenté) en contact, par sa face supérieure, avec la face inférieure de la couche 200.

La figure 2E illustre la structure obtenue à l'issue d'une étape de retrait de la couche de masque dur 203, par exemple au moyen d'une solution de gravure humide adaptée à graver le matériau de la couche 203 de façon sélective par rapport au matériau de la couche 200. La face supérieure de la couche 200 est ainsi libérée, et la couche 200 comprend, du côté de sa face supérieure, une microcavité concave 250, par exemple de forme hémisphérique ou en forme de portion de sphère. La profondeur de la microcavité 250 est inférieure à l'épaisseur de la couche 200.

Comme dans l'exemple des figures 1A à 1E, la microcavité 250 peut être utilisée directement comme microlentille optique concave, ou servir de moule pour la réalisation de microlentilles optiques concaves ou convexes, par exemple en un matériau polymère transparent.

A titre de variante, la microcavité 250 peut avoir d'autres applications. Par exemple, la microcavité 250 peut servir de réceptacle pour des applications microbiologiques, par exemple des applications de séparation et/ou comptage de cellules biologiques.

Un avantage du procédé des figures 2A à 2E est qu'il offre de nombreuses possibilités de contrôle de la forme des microcavités 250, en jouant notamment sur la dimension de l'ouverture 209 et/ou sur l'épaisseur du masque dur 203 et/ou sur la nature du matériau du masque dur 203. Dans le cas d'un masque dur 203 métallique ou en un matériau diélectrique à forte constante diélectrique, la forte sélectivité du masque dur à l'acide fluorhydrique en phase vapeur permet d'utiliser un masque 203 particulièrement mince, par exemple d'épaisseur inférieure à 50 nm, par exemple comprise entre 20 et 40 nm. Une épaisseur plus importante, par exemple supérieure à 50 nm, par exemple comprise entre 100 et 300 nm, peut toutefois être utilisée de manière à contrôler la diffusion des espèces et ainsi la forme de la microcavité 250. Par exemple, pour une même largeur d'ouverture 209, un masque dur 203 plus épais conduira à une microcavité plus large et plus profonde qu'un masque dur 203 plus fin. Le choix du matériau du masque dur 203 a en outre un impact sur la diffusion des espèces actives de gravure et ainsi sur la forme des microcavités 250. En particulier un masque dur 203 de nature métallique aura un effet galvanisateur lors de la gravure à base d'acide fluorhydrique en phase vapeur, qui aura un impact sur la forme et les dimensions de la microcavité 250.

On notera que l'utilisation d'une gravure HF vapeur limite les problématiques de contamination éventuelle des équipements liées à l'utilisation d'un masque dur de nature métallique. En effet, les équipements de gravure HF vapeur sont généralement utilisés pour des étapes de fabrication non sensibles aux contaminations métalliques, contrairement aux équipements de gravure humide qui doivent généralement être protégés de toute contamination métallique. En outre, contrairement aux procédés de gravure humide ou de gravure sèche par plasma, la gravure HF vapeur limite les transports de matière et donc les risques de contamination par le matériau du masque dur.

Un autre avantage du mode de réalisation des figures 2A à 2E est que la gravure HF vapeur permet de réaliser des microcavités de petites dimensions, de forme régulière et contrôlée, à travers des ouvertures 209 de faible largeur, par exemple de largeur inférieure à 500 nm, par exemple inférieure à 300 nm, par exemple inférieure à 150 nm, par exemple de l'ordre de 120 nm, ce qui serait difficile, voire impossible, avec une gravure humide.

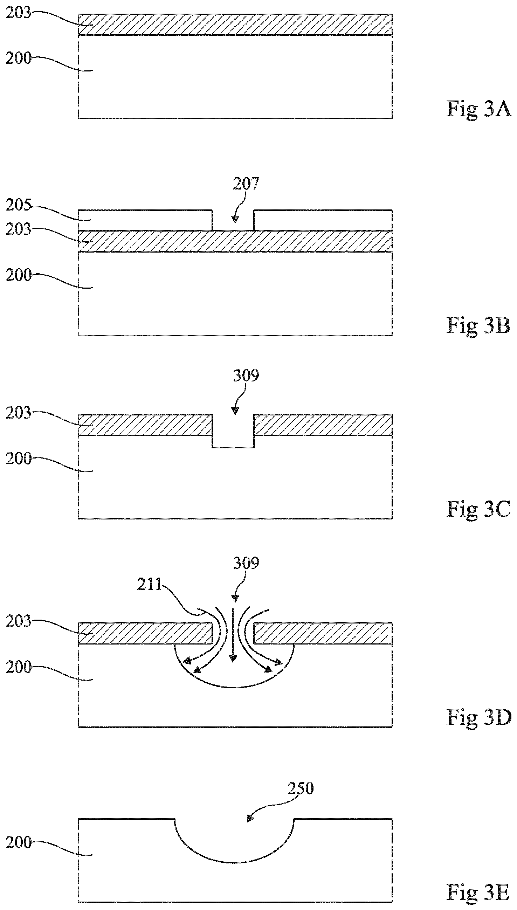

Les figures 3A à 3E sont des vues en coupe illustrant des étapes successives d'un autre exemple d'un procédé de fabrication d'une microcavité concave 250 dans une couche 200, selon un mode de réalisation.

Le procédé des figures 3A à 3E comprend des éléments communs avec le procédé des figures 2A à 2E. Ces éléments ne seront pas détaillés à nouveau ci-après et seules les différences par rapport au procédé des figures 2A à 2E seront mises en exergue.

La figure 3A illustre une étape identique ou similaire à l'étape de la figure 2A, de formation d'une couche de masque dur 203 sur la face supérieure de la couche 200.

La figure 3B illustre une étape identique ou similaire à l'étape de la figure 2B, de formation d'une couche de masquage 205 sur la face supérieure de la couche de masque dur 203, puis de formation, dans la couche 205, d'une ouverture traversante 207 débouchant sur la face supérieure de la couche de masque dur 203.

La figure 3C illustre la structure obtenue à l'issue d'une étape de gravure d'une ouverture traversante 309 dans la couche de masque dur 203, en utilisant la couche 205 comme masque de gravure, puis de retrait de la couche 205.

L'ouverture 309 est située à l'aplomb de l'ouverture 207 et alignée verticalement avec l'ouverture 207. L'ouverture 209 présente par exemple des dimensions latérales sensiblement identiques à celles de l'ouverture 207.

Cette étape est similaire à l'étape de formation de l'ouverture 209 de la figure 2C, à la différence près que, dans l'exemple de la figure 3C, l'ouverture 309 se prolonge verticalement dans une partie supérieure de la couche 200, sans la traverser entièrement.

La figure 3D illustre une étape similaire à l'étape de la figure 2D, de formation de la microcavité 250 par gravure partielle de couche 200 à travers l'ouverture 309 préalablement formée dans la couche de masque dur 203, par un procédé de gravure à base d'acide fluorhydrique en phase vapeur.

La figure 3E illustre la structure obtenue à l'issue d'une étape similaire à l'étape de la figure 2E de retrait de la couche de masque dur 203.

Dans l'exemple des figures 3A à 3E, le prolongement de l'ouverture 309 à travers une partie de l'épaisseur de la couche 200 offre un paramètre supplémentaire pour contrôler la diffusion des espèces lors de la gravure HF vapeur, et ainsi la forme et les dimensions des microcavités 250.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de dimensions mentionnés dans la présente description.

## Revendications

1. Procédé de fabrication d'une microcavité concave (250) dans une couche (200) d'un premier matériau, comprenant les étapes successives suivantes :
a) former une couche de masque dur (203) sur la couche (200) du premier matériau ;
b) former une ouverture (209 ; 309) dans la couche de masque dur (203) ; et
c) former la microcavité concave (250) par gravure partielle de la couche (200) du premier matériau à travers l'ouverture (209), par un procédé de gravure à base d'acide fluorhydrique en phase vapeur.

2. Procédé selon la revendication 1, dans lequel ladite couche (200) en le premier matériau est une couche d'oxyde de silicium.

3. Procédé selon la revendication 1 ou 2, dans lequel la couche de masque dur (203) est une couche métallique.

4. Procédé selon la revendication 3, dans lequel la couche de masque dur (203) est en nitrure de titane, en aluminium, en cuivre, ou en un alliage aluminium-cuivre.

5. Procédé selon la revendication 1 ou 2, dans lequel la couche de masque dur (203) est en un matériau diélectrique de constante diélectrique supérieure à celle de l'oxyde de silicium.

6. Procédé selon la revendication 5, dans lequel la couche de masque dur (203) est en nitrure d'aluminium, en alumine, ou en oxyde d'hafnium.

7. Procédé selon l'une quelconque des revendications 1 à 6, dans lequel ladite ouverture (209 ; 309) présente une largeur inférieure à 500 nm, de préférence inférieure à 300 nm.

8. Procédé selon l'une quelconque des revendications 1 à 7, dans lequel, à l'étape b), ladite ouverture (209 ; 309) est formée par gravure à travers une ouverture (207) préalablement formée par photolithographie dans une couche de résine photosensible (205).

9. Procédé selon l'une quelconque des revendications 1 à 8, dans lequel l'ouverture (309) formée à l'étape b) se prolonge à travers une partie de l'épaisseur de la couche (200) en le premier matériau.

10. Procédé selon l'une quelconque des revendications 1 à 9, comprenant, après l'étape c), une étape de retrait de la couche de masque dur (203).

11. Utilisation du procédé selon l'une quelconque des revendications 1 à 10 pour former des microlentilles optiques.

12. Utilisation du procédé selon l'une quelconque des revendications 1 à 10 pour former des microcavités destinées à servir de réceptacle pour des applications de microbiologie.
